# EUROPÄISCHE PATENTSCHRIFT

(11) **EP 2 994 948 B1**
(45) Veröffentlichungstag und Bekanntmachung des Hinweises auf die Patenterteilung: **26.02.2020**
(21) Anmeldenummer: 14723040.3
(22) Anmeldetag: 06.05.2014
(51) Int. Cl.: H01M 2/30, H01R 11/28, G01R 31/364, H01R 13/66

(54) **MECHANISCHES HALTEELEMENT ZUM HALTEN EINES STROMSENSORS AN EINER FAHRZEUGBATTERIE**
MECHANICAL RETAINING ELEMENT FOR HOLDING A CURRENT SENSOR ON A VEHICLE BATTERY
DISPOSITIF DE RETENUE MECANIQUE POUR MAINTENIR UN CAPTEUR DE COURANT SUR LA BATTERIE D'UN VEHICULE

(30) Priorität: 07.05.2013 DE 102013208375
(43) Veröffentlichungstag der Anmeldung: 16.03.2016
(73) Patentinhaber: Continental Teves AG & Co. OHG, 60488 Frankfurt am Main (DE)
(72) Erfinder: HAVERKAMP, Martin, 60385 Frankfurt (DE)
(86) Internationale Anmeldenummer: PCT/EP2014/059168
(87) Internationale Veröffentlichungsnummer: WO 2014/180811

(56) Entgegenhaltungen:
- WO-A1-2011/136398
- DE-A1-102010 031 113
- DE-A1-102011 000 943
- US-A1- 2010 316 901
- US-A1- 2012 270 452

## Beschreibung

Die Erfindung betrifft ein mechanisches Halteelement zum Halten eines Stromsensors an einer Fahrzeugbatterie, eine Polklemme für die Fahrzeugbatterie und die Fahrzeugbatterie.

Aus der Zeitschrift *"*elektronik industrie", Ausgabe Juli 2005 ist ein intelligenter Batteriesensor, IBS genannt bekannt. Dabei handelt es sich um einen Stromsensor, der eingerichtet ist, einen Ladestand einer Fahrzeugbatterie basierend auf der Batteriespannung, dem Batteriestrom und einer Temperatur der Batterie zu bestimmen. Relevanter Stand der Technik ist in den Druckschriften WO 2011/136398 A1, US 2012/270452 A1, DE 10 2011 000943 A1, US 2010/316901 A1 und DE 10 2010 031113 A1 beschrieben.

Es ist Aufgabe der vorliegenden Erfindung die Befestigung des bekannten Stromsensors an einer Fahrzeugbatterie zu verbessern.

Die Aufgabe wird durch die Merkmale der unabhängigen Ansprüche gelöst. Bevorzugte Weiterbildungen sind Gegenstand der abhängigen Ansprüche.

Gemäß einem Aspekt der Erfindung umfasst ein mechanisches Halteelement zum Halten eines Stromsensors mit einem elektrischen ersten Kontaktelement zum Herstellen einer elektrischen Verbindung mit einer Polklemme an einem Pol einer Fahrzeugbatterie, einem zweiten elektrischen Kontaktelement zum Herstellen einer elektrischen Verbindung eines elektrischen Anschlusselement und einem in Reihe zwischen dem ersten und dem zweiten Kontaktelement elektrisch verschalteten Strommessaufnehmer am Pol einer Fahrzeugbatterie, ein in einer Formschlussrichtung wirkendes erstes Formschlusselement zur formschlüssigen Aufnahme eines entsprechenden Gegenstücks an der Polklemme der Fahrzeugbatterie und ein entgegen der Formschlussrichtung wirkendes zweites Formschlusselement zur formschlüssigen Aufnahme eines entsprechenden Gegenstücks am elektrischen Anschlusselement, wobei die Polklemme, das Anschlusselement und das Halteelement jeweils verschiedene Teile sind und das Halteelement einstückig elektrisch isolierend aus Kunststoff gefertigt ist.

Der Erfindung liegt die Überlegung zugrunde, dass an der Fahrzeugbatterie die elektrische Verbindung zu dem eingangs genannten Stromsensor und am eingangs genannten Stromsensor die elektrische Verbindung zum elektrischen Anschlusselement zusätzlich den mechanischen Halt des Gesamtaufbaus sicherstellen müssen. Zwar könnte zur mechanischen Unterstützung auch eine zusätzliche Kontaktierung zwischen der Fahrzeugbatterie und dem elektrischen Anschlusselement geschaffen werden, diese müsste dann aber eine elektrische Isolation zwischen der Fahrzeugbatterie und dem elektrischen Anschlusselement bereitstellen, um einen Kurzschluss des Stromsensors zu vermeiden. Daher wäre es naheliegend für die zusätzliche Kontaktierung Schraubverbindungen zu nutzen, da hier ein hoher mechanischer Halt mit einer entsprechenden elektrischen Isolation einbringbar ist. Eine derartige Schraubverbindung wäre jedoch nicht ohne größeren Teileaufwand zu realisieren.

Hier setzt das angegebene mechanische Halteelement mit der Erkenntnis an, dass die Hauptbelastung zwischen dem elektrischen Anschlusselement und der Fahrzeugbatterie gewöhnlich in einer bestimmten Richtung wirkt. In dieser bestimmten Richtung kann das angegebene Halteelement die notwendige Stabilität bereitstellen. In allen anderen verbleibenden Belastungsrichtungen reicht die mechanische Stabilität der elektrischen Verbindungen zum Stromsensor aus. Auf diese Weise kann die elektrische Isolation mit einem einzigen Bauteil mit vergleichsweise geringem Montageaufwand, ohne Schrauben o.ä. bereitgestellt werden.

Erfindungsgemäß ist das angegebene mechanische Halteelement einstückig gefertigt, was den notwendigen Einzelteilaufwand zur Bereitstellung der oben genannten mechanischen Stabilität und gleichzeitig der elektrischen Isolierung auf ein Minimum reduziert.

Zwar könnte das mechanische Halteelement selbst elektrisch leitfähig sein, dann wäre aber eine zusätzliche Isolierungsschicht entweder zwischen dem mechanischen Halteelement und dem elektrischen Anschlusselement und/oder der Fahrzeugbatterie notwendig. Um dies zu vermeiden ist erfindungsgemäß das angegebene mechanische Halteelement selbst elektrisch isolierend ausgebildet.

In einer anderen Weiterbildung ist das mechanische Halteelement das aus einem elastischen Material gefertigt, so dass das mechanische Halteelement gegenüber dynamischen mechanischen Belastungen wie Schwingungen, Vibrationen und Stößen robust ausgebildet ist.

Erfindungsgemäß ist das angegebene mechanische Halteelement aus Kunststoff gefertigt, so dass es durch gießende und/oder spritzende Formgebungsverfahren wie beispielsweise Spritzguss in Massenproduktion herstellbar ist.

In einer bevorzugten Weiterbildung des angegebenen mechanischen Halteelements ist eines der Formschlusselemente rotationssymmetrisch um eine Rotationsachse ausgebildet, die senkrecht zur Formschlussrichtung steht. Auf diese Weise kann das mechanische Halteelement mit höheren Fertigungstoleranzen bereitgestellt werden, weil es einen Freiheitgrad aufweist, in dem es diese Fertigungstoleranzen aufnehmen kann.

In einer besonders bevorzugten Weiterbildung des angegebenen mechanischen Halteelements wirkt das andere Formschlusselement in einer zweiten Formschlussrichtung, die entgegengesetzt zur Formschlussrichtung und senkrecht zur Rotationsachse steht.

Gemäß einem weiteren Aspekt der Erfindung umfasst eine Polklemme zum Halten eines elektrischen Kabels an einem Pol einer Fahrzeugbatterie über einen Stromsensor mit einem elektrischen ersten Kontaktelement zum Herstellen einer elektrischen Verbindung, einem zweiten elektrischen Kontaktelement und einem in Reihe zwischen dem ersten und dem zweiten Kontaktelement elektrisch verschalteten Strommessaufnehmer, ein in einer Formschlussrichtung wirkendes Formschlusselement zur formschlüssigen Aufnahme eines entsprechenden Gegenstücks am oben genannten mechanischen Halteelement.

Gemäß einem weiteren Aspekt der Offenbarung umfasst ein elektrisches Kabel zum Anschließen an eine Polklemme einer Fahrzeugbatterie über einen Stromsensor mit einem elektrischen ersten Kontaktelement zum Herstellen einer elektrischen Verbindung, einem zweiten elektrischen Kontaktelement und einem in Reihe zwischen dem ersten und dem zweiten Kontaktelement elektrisch verschalteten Strommessaufnehmer, ein in einer Formschlussrichtung wirkendes Formschlusselement zur formschlüssigen Aufnahme eines entsprechenden Gegenstücks an der Polklemme der Fahrzeugbatterie. Die Polklemme kann dabei eines der oben genannten mechanischen Halteelemente umfassen. Alternativ kann das Gegenstück jedoch auch direkt an der Polklemme ausgebildet sein.

Gemäß einem weiteren Aspekt der Erfindung umfasst eine Fahrzeugbatterie zum Abgeben oder Aufnehmen eines elektrischen Stromes für ein Bordnetz eines Fahrzeuges eine angegebene Polklemme zum Abgeben oder Aufnehmen des elektrischen Stromes, und einen an die Polklemme angeschlossenen Stromsensor mit einem elektrischen ersten Kontaktelement zum Herstellen einer elektrischen Verbindung, einem zweiten elektrischen Kontaktelement und einem in Reihe zwischen dem ersten und dem zweiten Kontaktelement elektrisch verschalteten Strommessaufnehmer, wobei das Formschlusselement der Polklemme formschlüssig mit einem angegebenen mechanischen Halteelement verbindbar ist.

Die angegebene Fahrzeugbatterie kann um das angegebene mechanische Halteelement derart erweitert werden, dass das erste Formschlusselement mit dem Formschlusselement der Polklemme formschlüssig verbunden ist.

Weiter kann die angegebene Fahrzeugbatterie um das elektrische Anschlusselement erweitert werden, dessen Formschlusselement formschlüssig mit dem zweiten Formschlusselement des mechanischen Halteelements verbunden ist. Dabei kann dann das elektrische Anschlusselement elektrisch mit dem Stromsensor verbunden sein.

Die elektrische Verbindung zum Stromsensor kann auf Seiten der Polklemme und auf Seiten des elektrischen Anschlusselements eine Lötverbindung sein, die dann zusätzlich mechanischen Halt in Richtungen bereitstellt, die nicht vom Formschluss mit dem mechanischen Halteelement abgedeckt sind.

Das elektrische Anschlusselement kann direkt ein elektrisches Kabel aber auch ein elektrisches Verbindungselement, wie eine elektrische Brücke sein.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:
Fig. 1 ein Schaubild zur Verdeutlichung der grundsätzlichen Wirkungsweise einer möglichen Befestigung eines Kabels an einer Fahrzeugbatterie über einen Stromsensor;
Fig. 2 ein Schaubild zur Verdeutlichung der grundsätzlichen Wirkungsweise einer alternativen Befestigung eines Kabels an einer Fahrzeugbatterie über einen Stromsensor;
Fig. 3 eine perspektivische Einzelteilansicht eines eine Batteriepolklemme und ein Kabel miteinander verbindenden Stromsensors; und
Fig. 4 eine perspektivische Ansicht des die Batteriepolklemme und das Kabel miteinander verbindenden Stromsensors in einem zusammengesetzten Zustand zeigen.

In den Figuren werden gleiche technische Elemente mit gleichen Bezugszeichen versehen und nur einmal beschrieben.

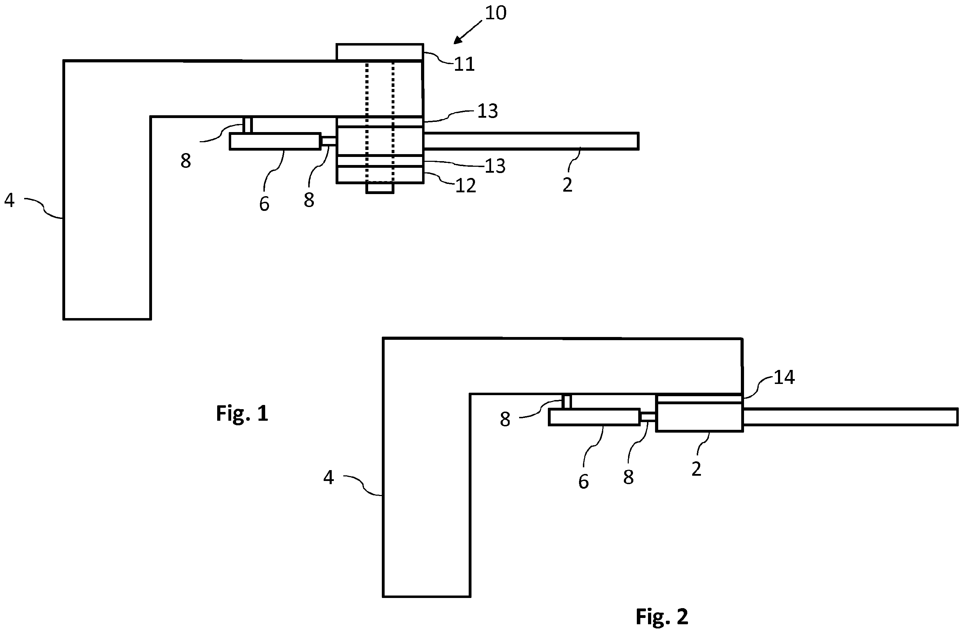

Es wird auf Fig. 1 Bezug genommen, die ein Schaubild zur Verdeutlichung der grundsätzlichen Wirkungsweise der Befestigung eines Kabels 2 an einem Anschlusselement 4 einer nicht weiter gezeigten Fahrzeugbatterie eines nicht weiter gezeigten Fahrzeuges über einen Stromsensor 6 zeigt.

Wie in Fig. 1 zu sehen, könnte das Kabel 2 unmittelbar an dem Fahrzeugbatterieanschluss 4 befestigt werden, um einen stabilen Halt zu gewährleisten. Der Stromsensor 6 könnte mittels elektrischen Lötstellen 8 in Reihe zwischen dem Kabel 2 und dem Fahrzeugbatterieanschluss 4 elektrisch verschalten werden. Diese elektrischen Lötstellen 8 würden dann jedoch nicht nur die elektrische Anbindung, sondern auch gleichzeitig den mechanischen Halt des Kabels 2 am Fahrzeugbatterieanschluss 4 über den Stromsensor 6 darstellen. Dieser mechanische Halt könnte insbesondere im Fahrzeugbau unzureichend sein, um ihn über einen längeren Zeitraum auch unter zufälligen Extrembelastungen zu gewährleisten. Um diesen Extrembelastungen gerecht zu werden müsste das Kabel 2 direkt am Fahrzeugbatterieanschluss 4 beispielsweise über ein zusätzliches mechanisches Stabilisierungselement 10 befestigt werden, so dass die mechanisches Beanspruchungen auf die Lötstellen 8 reduziert werden.

Sinnvolle Stabilisierungselemente 10 müssten hier jedoch nicht nur kostengünstig sondern auch in einfacher Weise montierbar sein. Hierzu könnten Schrauben 11 - Muttern 12 - Verbindungen verwendet werden, da diese als Massenware kostengünstig und genormt erhältlich sind. Jedoch sind diese Verbindungen aus Metall und würden so den Stromsensor 6 kurzschließen, so dass hier zusätzliche elektrische Isolationen 13 notwendig sind. Augenscheinlich ist der notwendige Teilaufwand hier sehr hoch, was nicht nur zu hohen Einzelteilkosten sondern auch zu einem hohen Montageaufwand führt.

Um diese hohen Einzelteilkosten und den hohen Montageaufwand zu vermeiden, wird vorgeschlagen, das Kabel 2 am Fahrzeugbatterieanschluss 4 mit einem mechanischen Halteelement 14 zu befestigen, das elektrisch isolierend wirkt. In besonders günstiger Weise kann das mechanische Halteelement 14 den Fahrzeugbatterieanschluss 4 und das Kabel über je einen Formschluss verbinden. Im Gegensatz zu einem Kraftschluss, der an getrennten Stellen eine Kraftquelle und eine Kraftaufnahmefläche und einem Stoffschluss, der fertigungstechnisch nur mit einem hohen Zeitaufwand herstellbar und darüber hinaus auch noch schwer wieder zu lösen ist, benötigt der Formschluss lediglich ein einziges Formschlussteil, das ferner auch noch elektrisch isolierend aufgebaut sein kann. In besonders günstiger Weise kann dabei die Tatsache ausgenutzt werden, dass für die Verbindung zwischen dem Kabel 2 und dem Fahrzeugbatterieanschluss 4 nur in bestimmten Richtungen beispielsweise bei Wartungsarbeiten durch Zug am Kabel 2 die zuvor genannten Extrembelastungen zu erwarten sind, während in anderen Richtungen (beispielsweise aus Platzmangel) mechanisch keine größeren Beanspruchungen auftreten können. Das als Formschlusselement ausgebildete mechanische Halteelement 14 könnte in seiner Formschlussrichtung die Verbindung zwischen dem Kabel 2 und dem Fahrzeugbatterieanschluss 4 in der Richtung verstärken, in der die zuvor genannte bei Wartungsarbeiten vergleichsweise zufällig auftretende Zugbelastung zu erwarten ist.

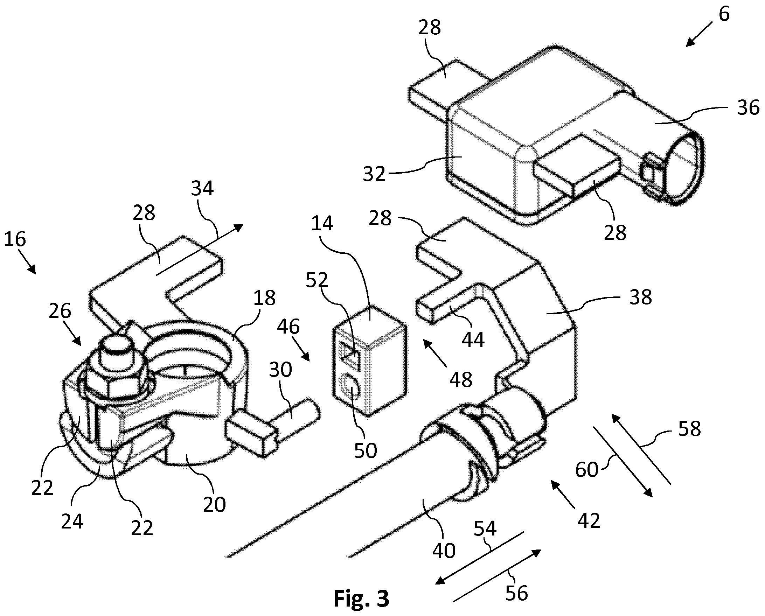

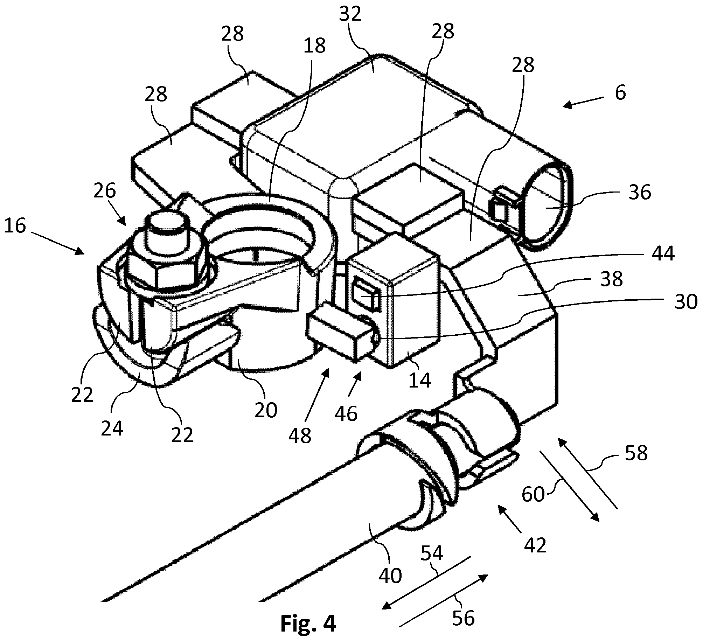

Das Prinzip dieses, als Formschlusselement ausgebildeten mechanischen Halteelements 14 soll nachstehend anhand von Fig. 3 und 4 näher erläutert werden.

In Fig. 3 ist ein Teil des Fahrzeugbatterieanschlusses 4 in Form einer Batteriepolklemme 16 gezeigt, die in einer an sich bekannten Weise an einem nicht weiter dargestellten Batteriepolbolzen eines Plus- oder Minuspols der oben genannten Fahrzeugbatterie befestigt werden kann.

Die Batteriepolklemme 16 umfasst einen in Umfangsrichtung geöffneten Zylinderkörper 18, an dessen Öffnungsschenkeln 20 (von denen in Fig. 3 nur einer sichtbar ist) je eine viertelkreisförmige Spannbacke 22 angeordnet ist, die sich zu einem Halbkreis schließen lassen. Der Halbkreis kann formschlüssig in einer Spannschale 24 aufgenommen werden, die über eine Schraubverbindung 26 über den Halbkreis gezogen werden kann. Die Batteriepolklemme 16 umfasst ferner einen elektrischen Stromanschluss 28, an dem in einer noch zu beschreibenden Weise der Stromsensor 6 elektrisch kontaktiert werden kann. Ferner umfasst die Batteriepolklemme 16 ein Formschlusselement in Form eines Kreiszylinderstiftes 30 für einen noch zu beschreibenden Formschluss.

Der Stromsensor 6 weist ein Gehäuse 32 auf, das von zwei elektrischen Stromanschlüssen 28 durchdrungen ist. Einer der beiden Stromanschlüsse 28 kann mit dem Stromanschluss 28 des Stromsensors 6 beispielsweise über eine Lötverbindung elektrisch verbunden werden, um einen elektrischen Strom 34 aus der genannten Fahrzeugbatterie durch den Stromsensor 6 zu leiten, damit dieser den elektrischen Strom 34 messen kann. Der elektrische Strom 34 kann dann über den weiteren Stromanschluss 28 in einer noch zu beschreibenden Weise an das Kabel 2 abgegeben werden. Die Daten zu dem gemessenen elektrischen Strom 34 können über eine Datenschnittstelle 36 beispielsweise einer nicht weiter gezeigten Motorsteuerung in dem eingangs genannten Fahrzeug zur weiteren Datenverarbeitung bereitgestellt werden. Auf Details zu dieser Datenschnittstelle 36 soll der Kürze halber verzichtet werden.

Das Kabel 2 kann über ein Anschlusselement 38 mit einem eigenen Stromanschluss 28 beispielsweise über eine weitere Lötverbindung an den weiteren Stromanschluss 28 des Stromsensors 6 elektrisch angeschlossen werden. Auf diese Weise kann der Stromsensor 6 elektrisch in Reihe zwischen die Batteriepolklemme 16 des Fahrzeugbatteriepols 4 und das Anschlusselement 38 des Kabels 2 verbunden werden. Das Anschlusselement 38 ist dabei mit einem Kabelkörper 40 des Kabels 2 über eine an sich bekannte Crimpverbindung 42 elektrisch und mechanisch verbunden. Ferner weist das Anschlusselement 38 einen Viereckzylinderstift 44 für einen weiteren noch zu beschreibenden Formschluss auf.

In der vorliegenden Ausführung ist das Anschlusselement 38 über das als Formschlusselement ausgebildete mechanische Halteelement 14 mit der Batteriepolklemme 16 mechanisch über die beiden zuvor genannten Formschlüsse verbunden, die der Übersichtlichkeit halber nachstehend mit dem Bezugszeichen 46 und 48 versehen werden sollen. Das mechanische Halteelement 14 weist dazu eine zum Kreiszylinderstift 30 passende kreisförmige Ausnehmung 50 und eine zum Viereckzylinderstift 44 passende viereckförmige Ausnehmung 52 auf.

Zur mechanischen Verbindung des Anschlusselements 38 mit der Batteriepolklemme 16 über das mechanische Halteelement 14 werden der Kreiszylinderstift 30 in die kreisförmige Ausnehmung 50 und der Viereckzylinderstift 44 in die viereckförmige Ausnehmung 52 entsprechend in einer ersten Verbindungsrichtung 54 und einer zweiten Verbindungsrichtung 56 eingeführt, so dass die entsprechenden Formschlussverbindungen 46, 48 entstehen. Auf diese Weise werden der Fahrzeugbatterieanschluss 4 über die Batteriepolklemme 16 und das Kabel 2 über das Anschlusselement 38 über das mechanische Halteelement 14 in der oben genannten Weise mechanisch in entsprechend einer ersten, rechtwinklig zur ersten Verbindungsrichtung 54 wirkenden ersten Formschlussrichtung 58 und einer zweiten, rechtwinklig zur zweiten Verbindungsrichtung 56 wirkenden zweiten Formschlussrichtung 60 gehalten. Zum Ausgleich von Fertigungstoleranzen ist die erste Formschlussverbindung 46 in Form eines Zylinderformschlusses 46 aufgebaut, im Rahmen dessen sich das Kabel 2 in Umfangrichtung um den Zylinderformschluss 46 drehen kann. Alternativ oder zusätzlich könnte auch die zweite, als Viereckformschluss 48 aufgebaute Formschlussverbindung 48 als Zylinderformschluss aufgebaut sein.

Der Viereckformschluss 48 kann beliebig aufgebaut sein, solange er Bewegungen der Formschlusspartner in Umfangsrichtung verhindert. So könnte der Viereckformschluss 48 beispielsweise auch statt des Viereckzylinderstifts 44 einen plattenförmigen Stift mit abgerundeten Kanten aufweisen, der in eine entsprechende Ausnehmung einführbar ist.

Das elektrische Halteelement ist erfindungsgemäß elektrisch isolierend aus Kunststoff, einstückig beispielsweise im Rahmen eines Spritzgussverfahrens gefertigt.

## Patentansprüche

1. Mechanisches Halteelement (14) zum Halten eines Stromsensors (6) mit einem elektrischen ersten Kontaktelement (28) zum Herstellen einer elektrischen Verbindung mit einer Polklemme (16) an einem Pol (4) einer Fahrzeugbatterie, einem zweiten elektrischen Kontaktelement (28) zum Herstellen einer elektrischen Verbindung eines elektrischen Anschlusselement (38) und einem in Reihe zwischen dem ersten und dem zweiten Kontaktelement (28) elektrisch verschalteten Strommessaufnehmer (32) am Pol (4) der Fahrzeugbatterie, umfassend:
- ein in einer Formschlussrichtung (58) wirkendes erstes Formschlusselement (50) zur formschlüssigen Aufnahme eines entsprechenden Gegenstücks (30) an der Polklemme (16) der Fahrzeugbatterie und
- ein entgegen der Formschlussrichtung (58) wirkendes zweites Formschlusselement (52) zur formschlüssigen Aufnahme eines entsprechenden Gegenstücks (44) am elektrischen Anschlusselement (38),
wobei die Polklemme (16), das Anschlusselement (38), der Stromsensor (6) und das Halteelement (14) jeweils verschiedene Teile sind und das Halteelement (14) einstückig elektrisch isolierend aus Kunststoff gefertigt ist.

2. Mechanisches Halteelement (14) nach Anspruch 1, das aus einem elastischen Material gefertigt.

3. Mechanisches Halteelement (14) nach einem der vorstehenden Ansprüche, wobei eines der Formschlusselemente (50, 52) rotationssymmetrisch um eine Rotationsachse ausgebildet ist, die senkrecht zur Formschlussrichtung (58) steht.

4. Mechanisches Halteelement (14) nach Anspruch 3, wobei das andere Formschlusselement (52, 50) in einer zweiten Formschlussrichtung (60) wirkt, die entgegengesetzt zur Formschlussrichtung (58) und senkrecht zur Rotationsachse steht.

5. Polklemme (16) zum Halten eines elektrischen Kabels (2) an einem Pol (4) einer Fahrzeugbatterie über einen Stromsensor (6) mit einem elektrischen ersten Kontaktelement (28) zum Herstellen einer elektrischen Verbindung, einem zweiten elektrischen Kontaktelement (28) und einem in Reihe zwischen dem ersten und dem zweiten Kontaktelement (28) elektrisch verschalteten Strommessaufnehmer (32), umfassend ein in einer Formschlussrichtung (58) wirkendes Formschlusselement (30) zur formschlüssigen Aufnahme eines entsprechenden Gegenstücks (50) am mechanischen Halteelement (14) nach einem der vorstehenden Ansprüche.

6. Fahrzeugbatterie zum Abgeben oder Aufnehmen eines elektrischen Stromes (34) für ein Bordnetz eines Fahrzeuges umfassend:
- eine Polklemme (4) nach Anspruch 5 zum Abgeben oder Aufnehmen des elektrischen Stromes (34), und
- einen an die Polklemme (4) angeschlossenen Stromsensor (6) mit einem elektrischen ersten Kontaktelement (28) zum Herstellen einer elektrischen Verbindung, einem zweiten elektrischen Kontaktelement (28) und einem in Reihe zwischen dem ersten und dem zweiten Kontaktelement (28) elektrisch verschalteten Strommessaufnehmer (32),
- wobei das Formschlusselement (30) der Polklemme (16) des Pols (4) formschlüssig mit einem mechanischen Halteelement (14) nach einem der Ansprüche 1 bis 4 verbindbar ist.

## Claims

1. Mechanical holding element (14) for holding a current sensor (6) having an electrical first contact element (28) for producing an electrical connection to a pole terminal (16) at a pole (4) of a vehicle battery, a second electrical contact element (28) for producing an electrical connection of an electrical connection element (38), and a current measurement pickup (32) at the pole (4) of the vehicle battery, said current measurement pickup being electrically interconnected in series between the first and the second contact element (28), comprising:
- a first positive-locking element (50) acting in a positive-locking direction (58) for receiving a corresponding mating piece (30) in a positive-locking manner at the pole terminal (16) of the vehicle battery and
- a second positive-locking element (52) acting counter to the positive-locking direction (58) for receiving a corresponding mating piece (44) in a positive-locking manner at the electrical connection element (38),
wherein the pole terminal (16), the connection element (38), the current sensor (6) and the holding element (14) are each different parts and the holding element (14) is produced in one piece from plastic so as to be electrically insulating.

2. Mechanical holding element (14) according to Claim 1, which is produced from an elastic material.

3. Mechanical holding element (14) according to either of the preceding claims, wherein one of the positive-locking elements (50, 52) is designed so as to be rotationally symmetrical about an axis of rotation, which is perpendicular to the positive-locking direction (58).

4. Mechanical holding element (14) according to Claim 3, wherein the other positive-locking element (52, 50) acts in a second positive-locking direction (60), which is opposite to the positive-locking direction (58) and perpendicular to the axis of rotation.

5. Pole terminal (16) for holding an electrical cable (2) at a pole (4) of a vehicle battery by means of a current sensor (6) having an electrical first contact element (28) for producing an electrical connection, a second electrical contact element (28) and a current measurement pickup (32) electrically interconnected in series between the first and the second contact element (28), comprising a positive-locking element (30) acting in a positive-locking direction (58) for receiving a corresponding mating piece (50) in a positive-locking manner at the mechanical holding element (14) according to one of the preceding claims.

6. Vehicle battery for outputting or receiving an electric current (34) for an on-board power supply system of a vehicle comprising:
- a pole terminal (4) according to Claim 5 for outputting or receiving the electric current (34), and
- a current sensor (6) connected to the pole terminal (4) and having an electrical first contact element (28) for producing an electrical connection, a second electrical contact element (28) and a current measurement pickup (32) electrically interconnected in series between the first and the second contact element (28),
- wherein the positive-locking element (30) of the pole terminal (16) of the pole (4) is able to be connected in a positive-locking manner to a mechanical holding element (14) according to one of Claims 1 to 4.

## Revendications

1. Élément de maintien mécanique (14) destiné à maintenir un capteur de courant (6) comprenant un premier élément de contact électrique (28) destiné à établir une liaison électrique avec une borne polaire (16) au niveau d'un pôle (4) d'une batterie de véhicule, un deuxième élément de contact électrique (28) destiné à établir une liaison électrique d'un élément de raccordement électrique (38) et un enregistreur de mesure de courant (32) connecté électriquement en série entre le premier et le deuxième élément de contact (28) au niveau du pôle (4) de la batterie de véhicule, comprenant :
- un premier élément d'assemblage par complémentarité de formes (50), agissant dans une direction d'assemblage par complémentarité de formes (58), destiné à accueillir par complémentarité de formes une pièce homologue (30) correspondante au niveau de la borne polaire (16) de la batterie de véhicule et
- un deuxième élément d'assemblage par complémentarité de formes (52), agissant à l'opposé de la direction d'assemblage par complémentarité de formes (58), destiné à accueillir par complémentarité de formes une pièce homologue (44) correspondante au niveau de l'élément de raccordement électrique (38),
la borne polaire (16), l'élément de raccordement (38), le capteur de courant (6) et l'élément de maintien (14) étant respectivement des parties différentes et l'élément de maintien (14) étant fabriqué en matière plastique monobloc en étant électriquement isolant.

2. Élément de maintien mécanique (14) selon la revendication 1, qui est fabriqué en un matériau élastique.

3. Élément de maintien mécanique (14) selon l'une des revendications précédentes, l'un des éléments d'assemblage par complémentarité de formes (50, 52) étant configuré à symétrie de rotation autour d'un axe de rotation qui est perpendiculaire à la direction d'assemblage par complémentarité de formes (58).

4. Élément de maintien mécanique (14) selon la revendication 3, l'autre élément d'assemblage par complémentarité de formes (52, 50) agissant dans une deuxième direction d'assemblage par complémentarité de formes (60) qui est opposée à la direction d'assemblage par complémentarité de formes (58) et perpendiculaire à l'axe de rotation.

5. Borne polaire (16) destinée à maintenir un câble électrique (2) au niveau d'un pôle (4) d'une batterie de véhicule au-dessus d'un capteur de courant (6) comprenant un premier élément de contact électrique (28) destiné à établir une liaison électrique, un deuxième élément de contact électrique (28) et un enregistreur de mesure de courant (32) connecté électriquement en série entre le premier et le deuxième élément de contact (28), comprenant un élément d'assemblage par complémentarité de formes (30), agissant dans une direction d'assemblage par complémentarité de formes (58), destiné à accueillir par complémentarité de formes une pièce homologue (50) correspondante au niveau de l'élément de maintien mécanique (14) selon l'une des revendications précédentes.

6. Batterie de véhicule destinée à délivrer ou à absorber un courant électrique (34) pour un réseau de bord d'un véhicule, comprenant :
- une borne polaire (4) selon la revendication 5 destinée à délivrer ou à absorber le courant électrique (34), et
- un capteur de courant (6) raccordé à la borne polaire (4), comprenant un premier élément de contact électrique (28) destiné à établir une liaison électrique, un deuxième élément de contact électrique (28) et un enregistreur de mesure de courant (32) connecté électriquement en série entre le premier et le deuxième élément de contact (28),
- l'élément d'assemblage par complémentarité de formes (30) de la borne polaire (16) du pôle (4) pouvant être relié par complémentarité de formes avec un élément de maintien mécanique (14) selon l'une des revendications 1 à 4.
